# EUROPÄISCHE PATENTSCHRIFT

(11) **EP 4 055 624 B1**
(45) Veröffentlichungstag und Bekanntmachung des Hinweises auf die Patenterteilung: **27.09.2023**
(21) Anmeldenummer: 19805159.1
(22) Anmeldetag: 08.11.2019
(51) Int. Cl.: H01L 21/67, H01L 21/18, H01L 21/683, H01L 21/20

(54) **VORRICHTUNG UND VERFAHREN ZUM VERBINDEN VON SUBSTRATEN**
APPARATUS AND METHOD FOR BONDING OF SUBSTRATES
APPAREIL ET MÉTHODE POUR LA LIAISON DE SUBSTRATS

(43) Veröffentlichungstag der Anmeldung: 14.09.2022
(73) Patentinhaber: EV Group E. Thallner GmbH, 4782 St. Florian am Inn (AT)
(72) Erfinder: BURGGRAF, Jürgen, 4780 Schärding (AT)
(74) Vertreter: Schneider, Sascha
(86) Internationale Anmeldenummer: PCT/EP2019/080718
(87) Internationale Veröffentlichungsnummer: WO 2021/089173

(56) Entgegenhaltungen:
- US-A- 5 129 827
- US-A1- 2006 205 179
- US-A1- 2007 274 669
- US-A1- 2014 072 774

## Beschreibung

Die vorliegende Erfindung betrifft ein Verfahren zum Verbinden eines ersten Substrats mit einem zweiten Substrat sowie eine korrespondierende Vorrichtung gemäß den nebengeordneten Ansprüchen.

Im Stand der Technik existieren sehr viele Methoden um zwei Substrate miteinander zu verbinden. Unabhängig vom grundsätzlichen Bondvorgang ist es fast immer so, dass mindestens ein erstes Substrat konvex gekrümmt und zentrisch mit einem zweiten Substrat in Kontakt gebracht wird. Der vollflächige Bond kommt dann durch eine kontinuierliche Kontaktierung vom Zentrum zum Rand der Substrate zustande. Diese Kontaktierungsart findet man beim Fusions- und Metall-, aber auch beim Temporärbonden wieder. Insbesondere bei der Fixierung eines Substrats auf einer Folie existieren andere Möglichkeiten der Kontaktierung. So wird eine Folie sehr oft auf ein Substrat laminiert. Der Kontaktierungsvorgang findet dabei vorwiegend durch eine Manipulation der Folie statt. Dabei wird das Substrat fixiert und flach gehalten. Eine spezielle Vorrichtung, ein sogenannter Laminierer, zieht danach eine Folie über das Substrat. Die Folie kann durch mechanische Elemente, insbesondere Rollen, oder einfach nur durch Absenken auf dem Substrat fixiert werden.

Die Dokumente US5129827-A, US2014/0072774-A1, US2006/0205179-A1 und US2007/0274669-A1 zeigen Verfahren und Vorrichtungen aus dem Stand der Technik. Aufgabe der vorliegenden Erfindung ist es, eine Vorrichtung und ein Verfahren zum Verbinden zweier Substrate vorzusehen, mit dem die Verbindungsgenauigkeit erhöht wird.

Die vorliegende Aufgabe wird mit den Merkmalen der unabhängigen Ansprüche gelöst. Vorteilhafte Weiterbildungen der Erfindung sind in den Unteransprüchen angegeben. Der Schutzbereich des Patents wird durch die Patentansprüche bestimmt.

Bei angegebenen Wertebereichen sollen auch innerhalb der genannten Grenzen liegende Werte als Grenzwerte offenbart gelten und in beliebiger Kombination beanspruchbar sein.

Die Erfindung betrifft ein Verfahren zum Verbinden eines ersten Substrats mit einem zweiten Substrat an Kontaktflächen der Substrate mit folgenden Schritten, insbesondere folgendem Ablauf:
- Aufnahme des ersten Substrats an einer ersten Aufnahmefläche eines ersten Substrathalters und Aufnahme des zweiten Substrats an einer zweiten Aufnahmefläche eines zweiten Substrathalters, wobei die Substrathalter in einer, insbesondere vakuumdicht schließbaren, Kammer angeordnet sind,
- Kontaktierung der Kontaktflächen an einer Verbindungsinitiierungsfläche, wobei eine ringförmige Kontaktierung erfolgt,
- Verbinden des ersten Substrats mit dem zweiten Substrat von der Verbindungsinitiierungsfläche zum Zentrum der Substrate.

Bevorzugt ist vorgesehen, dass nach der Kontaktierung und/oder während des Verbindens ein Kammerdruck in der Kammer erhöht wird.

In Weiterbildung der Erfindung ist vorgesehen, dass die Verbindungsinitiierungsfläche am Umfangsrand mindestens einer der Kontaktflächen angeordnet ist.

Weiter bevorzugt ist vorgesehen, dass vor der Kontaktierung eine konkave Verformung des ersten Substrats gegenüber dem zweiten Substrat, insbesondere durch Aufnahme des ersten Substrats an der entsprechend konkav gekrümmten ersten Aufnahmefläche, erfolgt.

Gemäß einem weiteren Aspekt der Erfindung ist vorgesehen, dass die, insbesondere umfangsgeschlossene, Verbindungsinitiierungsfläche ringförmig, insbesondere kreisringförmig, vorzugsweise konzentrisch zum Zentrum der Substrate verlaufend ausgebildet ist.

Besonders vorteilhaft ist eine Ausführung der Erfindung, bei der das erste Substrat und/oder das zweite Substrat ausschließlich im Bereich von Seitenrändern der Kontaktflächen rückwärtig an den ersten und/oder zweiten Aufnahmeflächen fixiert werden.

Die Erfindung betrifft eine Vorrichtung zum Verbinden eines ersten Substrats mit einem zweiten Substrat an Kontaktflächen der Substrate mit:
- einer ersten Aufnahmefläche eines ersten Substrathalters (lo) zur Aufnahme des ersten Substrats,
- einer zweiten Aufnahmefläche eines zweiten Substrathalters zur Aufnahme des zweiten Substrats,
- einer, insbesondere vakuumdicht schließbaren, Kammer, in der die Substrathalter angeordnet sind,
- Mitteln zur Kontaktierung der Kontaktflächen an einer Verbindungsinitiierungsfläche, wobei eine ringförmige Kontaktierung erfolgt,
- Mitteln zum Verbinden des ersten Substrats mit dem zweiten Substrat von der Verbindungsinitiierungsfläche zum Zentrum der Substrate.

Der Erfindung liegt der Gedanke zugrunde, dass eine Verbindung der Substrate von einer ringförmigen Verbindungsinitiierungsfläche zu einem Zentrum der Kontaktflächen erfolgt. Vorzugsweise wird mindestens eines der beiden Substrate, vorzugsweise das zweite und/oder obere Substrat zur Ausrichtung der Kontaktflächen vor der Kontaktierung konkav gegenüber dem anderen Substrat verformt. Mit Verformung ist insbesondere ein von einem Ausgangszustand, insbesondere Ausgangsgeometrie, der Substrate abweichender Zustand gemeint. Vorzugsweise wird das Verbinden nach einer Kontaktierung der Kontaktflächen insbesondere durch Fallenlassen/Loslösen des ersten/oberen Substrats, vorzugsweise unterstützt mittels einer Druckerhöhung, initiiert. Entsprechende Verbindungsmittel sind vorrichtungsgemäß vorgesehen.

Ein, insbesondere eigenständiger Erfindungsaspekt betrifft ein Verfahren und eine Vorrichtung zum Bonden/Laminieren eines zweiten Substrats, insbesondere Wafers, auf ein zweites Substrat, insbesondere einen anderen Wafer oder eine Folie. Insbesondere kann das zweite Substrat auch als Träger bezeichnet werden. Der Idee liegt dabei der Gedanke zugrunde, das Substrat in einer konkaven Form auf einem konkav gestalteten Substrathalter zu fixieren, konkav mit einem anderen Substrat an einer Verbindungsinitiierungsfläche zu kontaktieren, insbesondere vorzufixieren, und danach eine Druckdifferenz für die Erzeugung eines homogenen Drucks auf die Oberfläche des zu bondenden Substrats auszunutzen, um den vollflächigen Bond zu erzeugen. Die Druckdifferenz wird zwischen einem durch die kontaktierten Kontaktflächen der Substrate gebildeten Hohlraum und dem Kammerraum erzeugt. Denkbar ist auch, dass der Substrathalter seine Oberfläche durch Steuerelemente, insbesondere konkav, krümmen kann.

Eine homogene, Druckverteilung sorgt vorteilhaft für eine gleichmäßige Anpresskraft des zweiten Substrats auf das erste Substrat, da durch die Verwendung eines homogenen Drucks eine gleichmäßige Druckbeaufschlagung über die gesamte Fläche des Substrats erfolgt. Des Weiteren kann eine leicht erzeugbare Druckdifferenz verwendet werden und auf die Verwendung von Pins oder anderen mechanischen Elementen verzichtet werden, die nur mit einer lokalen Kraft angreifen.

Ein weiterer Erfindungsaspekt besteht in der Verwendung eines isostatischen Drucks, um ein, insbesondere steifes, Substrat auf einem anderen Substrat, das auch steif sein kann, zu fixieren. Das zu fixierende Substrat ist dabei vor der Erzeugung der Druckdifferenz konkav gekrümmt und liegt daher nur mit der Randfläche (Verbindungsinitiierungsfläche) auf. Die erfindungsgemäße Idee nicht nur auf das Bonden oder Laminieren einer Folie mit einem Substrat eingeschränkt, sondern betrifft bevorzugt zwei, insbesondere steife, Substrate. Die erfindungsgemäße Idee kann insbesondere auch zum Fusions- oder Metallbonden verwendet werden. Bevorzugt werden das erfindungsgemäße Verfahren und die erfindungsgemäße Vorrichtung allerdings für das Temporärbonden verwendet. Die Dicke einer erfindungsgemäß verwendeten Folie liegt zwischen 1 µm und 4000µm, vorzugsweise zwischen 1µm und 3500µm, noch bevorzugter zwischen 1µm und 3000µm, am bevorzugtesten zwischen 1µm und 2500µm, am allerbevorzugtesten zwischen 1µm und 2000µm.

### Substrate

Es werden unterschiedliche Arten von Substraten erwähnt, wobei (insbesondere strukturierte) Wafer, insbesondere mit einer Kleberschicht, Rahmen mit Folie in Frage kommen. Solche Substrate sind dem Fachmann an sich bekannt. Die Substrate können über eine Klebeschicht verfügen. Die Dicke der Klebeschicht liegt zwischen 1µm und 250µm, vorzugsweise zwischen 2µm und 200µm, noch bevorzugter zwischen 3µm und 100µm, am bevorzugtesten zwischen 3µm und 50µm, am allerbevorzugtesten zwischen 3µm und 10µm.

### Substrathalter

Als Substrathalter kommen insbesondere Substrathalter mit einer ebenen Aufnahmefläche oder einer konkav gekrümmten Aufnahmefläche in Frage.

Die Substrathalter verfügen vorzugsweise über Fixierungen zum Festhalten/Fixieren/Aufnehmen der Substrate. Bei den Fixierungen kann es sich insbesondere um
1. Mechanische Fixierungen, insbesondere Klemmen, und/oder
2. Vakuumfixierungen, insbesondere mit einzeln ansteuerbaren und/oder miteinander verbundenen, Vakuumbahnen, und/oder
3. Elektrische Fixierungen, insbesondere elektrostatische Fixierungen, und/oder
4. Magnetische Fixierungen, und/oder
5. Adhäsive Fixierungen, insbesondere Gel-Pak Fixierungen, und/oder
6. Fixierungen mit adhäsiven, insbesondere ansteuerbaren, Oberflächen handeln. Die Fixierungen sind insbesondere elektronisch ansteuerbar. Die Vakuumfixierung ist die bevorzugte Fixierungsart.

Die Vakuumfixierung besteht vorzugsweise aus mehreren Vakuumbahnen, die an der Oberfläche des Substrathalters (Aufnahmefläche) austreten. Die Vakuumbahnen sind vorzugsweise einzeln ansteuerbar. In einer technisch eher realisierbaren Anwendung sind einige Vakuumbahnen zu Vakuumbahnsegmenten vereint, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert. Dadurch wird eine gezielte, radialsymmetrische, insbesondere von innen nach außen durchgeführte Fixierung und/oder Loslösung eines Substrats vom Substrathalter oder umgekehrt ermöglicht. Derartige Vakuumsegmentausführungen werden in der Druckschrift WO2017162272A1 offenbart.

Die Substrathalter können an wohldefinierten Positionen oder über das gesamte Volumen transparent für einen Teil des elektromagnetischen Spektrums, insbesondere für UV-Licht und/oder sichtbare Licht und/oder Infrarotlicht sein. Denkbar ist auch, dass die Substrathalter an mehreren Positionen über Durchgänge, insbesondere Löcher, am bevorzugtesten Bohrungen, verfügen, durch welche eine freie Sicht auf die Substratfixierseite gewährleistet werden kann. Durch diese konstruktionstechnischen Maßnahmen wird insbesondere die Sicht auf Ausrichtungsmarken, die sich auf den Substraten befinden können, gewährleistet.

Im weiteren Verlauf des Textes werden die erfindungsgemäß bevorzugten Substrathalter genauer beschrieben.

Diese verfügen insbesondere über konkav gekrümmte Aufnahmeflächen. Die Krümmung der konkaven Aufnahmefläche ist vorzugsweise konstant und/oder rotationssymmetrisch. Insbesondere kann die Krümmung der konkaven Aufnahmefläche durch einen Krümmungsradius beschrieben werden. Der Krümmungsradius ist der Radius des Schmiegekreises an und durch das Zentrum der konkaven Aufnahmefläche. Der Krümmungsradius liegt zwischen 10 mm und 10⁸ mm, vorzugsweise zwischen 10³ mm und 10⁸ mm, noch bevorzugter zwischen 10⁴ mm und 10⁸ mm, am bevorzugtesten zwischen 10⁵ mm und 10⁸ mm, am allerbevorzugtesten zwischen 10⁶ mm und 10⁸mm. Für spezielle Ausführungsformen ist es denkbar, dass die Krümmung der konkaven Aufnahmefläche nicht konstant ist, sondern sich vom Zentrum zum Rand hin, insbesondere kontinuierlich, ändert. Bei dieser besonderen Ausführungsform wäre an jedem Punkt der Aufnahmefläche ein anderer Krümmungsradius vorgesehen.

In einer ersten Ausführungsform der konkaven Aufnahmefläche ist die Krümmung an jeder Position gleich, d.h. homogen.

In einer zweiten Ausführungsform der konkaven Aufnahmefläche wäre die Krümmung zumindest entlang eines Kreises konstant, d.h. würde sich nur vom Zentrum zum Rand hin ändern. Die Krümmung wäre entsprechend radialsymmetrisch.

In einer dritten Ausführungsform der konkaven Aufnahmefläche ist die Krümmung anisotrop, d.h. abhängig von der Radiusposition und von der Richtung. In dieser speziellen Ausführungsform wäre es beispielsweise erfindungsgemäß möglich, ein erstes Substrat so zu fixieren, dass beim Kontakt mit einem ebenen zweiten Substrat das erste Substrat nicht vollumfänglich entlang des umfänglichen Seitenrandes seiner Kontaktfläche aufliegt, sondern nur Teile des Umfangs des Seitenrandes das zweite Substrat kontaktieren. Ein Beispiel für eine solche Ausführungsform wäre ein auf einer ebenen Fläche abgelegter Sattel. Diese erfindungsgemäße Ausführungsform erlaubt insbesondere die Evakuierung des Zwischenraums zweier miteinander kontaktierter Substrate, nachdem der Kontakt erfolgt ist.

Des Weiteren können die erfindungsgemäßen Substrathalter bezüglich der Verformbarkeit der konkaven Aufnahmefläche charakterisiert werden.

In einer ersten erfindungsgemäßen Ausführungsform ist der erfindungsgemäße Substrathalter mit einer statischen, konkaven Aufnahmefläche versehen. Die konkave Aufnahmefläche wird insbesondere durch Fräs- und/oder Schleif- und/oder Polierprozesse hergestellt. Denkbar ist auch die Herstellung durch einen Rotationsprozess, bei dem eine aushärtbare Flüssigkeit in einem Zylinder in Rotation versetzt und ausgehärtet wird, so dass sich beim Aushärten eine konkav gekrümmte Aufnahmefläche bildet.

In einer zweiten erfindungsgemäßen Ausführungsform ist der erfindungsgemäße Substrathalter mit einer dynamisch veränderlichen, konkaven Aufnahmefläche versehen. Da die Verformung der konkaven Aufnahmefläche sich in relativ kleinen Dimensionen, insbesondere im Mikrometer bis Millimeterbereich abspielt, ist die Verwendung von funktionalen Materialien und Werkstoffen denkbar. Insbesondere könnten
- Magnetrheologische Materialien und/oder
- Elektrorheologische Materialien und/oder
- Formgedächtnislegierungen und/oder
- Gel-Paks und/oder
- Mechanische Bauelemente und/oder
- Elektrische Bauelemente und/oder
- Magnetische Bauelemente
für die Anpassung der konkaven Krümmung verwendet werden.

Des Weiteren können die erfindungsgemäßen Substrathalter bezüglich weiterer funktionaler Eigenschaften charakterisiert werden, die nachfolgend an Hand von Ausführungsformen der Erfindung beschrieben werden.

Gemäß einer ersten erfindungsgemäßen Ausführungsform ist der Substrathalter, vorzugsweise gänzlich, opak (d.h. undurchsichtig) für eine zur Vermessung von Substratoberflächen vorgesehene elektromagnetische Strahlung. Die Vermessung erfolgt insbesondere zur Steuerung der Substrathalter bei der Ausrichtung der Substrate zueinander.

In einer zweiten erfindungsgemäßen Ausführungsform ist der Substrathalter, insbesondere teilweise, vorzugsweise vollständig, transparent (d.h. durchsichtig) für die zur Vermessung von Substratoberflächen vorgesehene elektromagnetische Strahlung. Die Transparenz kann sich auch nur auf Teilbereiche des Substrathalters beziehen.

Die Transparenz wird durch den Transmissionsgrad beschrieben, der das Verhältnis aus transmittierter und eingestrahlter Strahlung angibt. Der Transmissionsgrad ist allerdings von der Dicken des durchstrahlten Körpers abhängig und damit keine materialspezifische Eigenschaft. Die Werte des Transmissionsgrades werden daher auf eine Einheitslänge von 1 cm bezogen angegeben. Das Material der transparenten Teile des Substrathalters besitzt in Bezug auf die gewählte Dicke von 1 cm und für die jeweils gewählte Wellenlänge insbesondere einen Transmissionsgrad größer 10%, vorzugsweise größer 20%, noch bevorzugter größer 50%, am bevorzugtesten größer als 75%, am allerbevorzugtesten größer 99%.

In einer dritten erfindungsgemäßen Ausführungsform ist der Substrathalter mit Durchgängen, insbesondere Bohrungen versehen, durch welche eine Beobachtung eines Substrats bzw. Substratstapels ermöglicht wird.

In einer vierten erfindungsgemäßen Ausführungsform ist der Substrathalter so konstruiert, dass die konkave Aufnahmefläche von einer Schicht oder einem Bauteil erzeugt wird, welches in der Lage ist, sich dynamisch, insbesondere durch Volumenänderung, anzupassen. Eine derartige Ausführungsform ist vor allem für die Konstruktion eines erfindungsgemäßen Substrathalters mit dynamisch veränderlicher Aufnahmefläche geeignet.

In einer fünften erfindungsgemäßen Ausführungsform ist der Substrathalter so konstruiert, dass die konkave Aufnahmefläche durch Stellmittel, insbesondere mechanische und/oder fluiddynamische und/oder elektrische gekrümmt werden kann. Dabei wird die Elastizität des Bauteils, welches die konkave Aufnahmefläche bildet, ausgenutzt. Da die Krümmungsradien der erfindungsgemäßen konkaven Aufnahmeflächen sehr groß, d.h. die Durchbiegungen sehr klein sind, reicht eine minimale translatorische Verschiebung des mit dem Stellmittel verbundenen Bauteils um eine Krümmungsänderung zu bewirken. Die Stellmittel werden insbesondere durch eine Steuerung zur Einstellung der Krümmung gesteuert.

### Anlage (Vorrichtung)

Die Erfindung umfasst eine Anlage, bestehend aus mindesten zwei Substrathaltern in einer, insbesondere druckdicht schließbaren, Kammer.

Mindestens einer der Substrathalter kann fixiert und/oder gedreht und/oder translatorisch bewegt werden. Die Rotation erfolgt insbesondere um mindestens eine, vorzugsweise drei zueinander orthogonal stehende, Achsen. Die Translation erfolgt insbesondere entlang mindestens einer, vorzugsweise entlang drei zueinander orthogonal stehenden, Achsen. Die Anlage verfügt vorzugsweise über Mittel zur Grob- und/oder Feinjustierung der Substrate zueinander.

Bei den Mitteln zur Grobjustierung handelt es sich vorzugsweise um mechanische Anschlagelemente, die ein Substrat in seiner translatorischen Bewegungsfreiheit begrenzen. Denkbar sind beispielsweise Stifte, an die ein Substrat herangeführt wird bis es zum Kontakt kommt.

Bei den Mitteln zur Feinjustierung handelt es sich vorzugsweise um optische Elemente, insbesondere Optiken, welche Ausrichtungsmarken, die sich vorzugsweise am Substrat befinden, detektieren können. Die detektierten Ausrichtungsmarken werden von einer Kamera aufgenommen und mit Hilfe einer Soft- und/oder Hard- und/oder Firmware verarbeitet. Hiermit erfolgt die Steuerung der Feinjustierung (Ausrichtung/Alignment) durch die Steuereinrichtung.

Die Auflösung der Optiken ist besser als 100 µm, vorzugsweise besser als 10 µm, noch bevorzugter besser als 1 µm, am bevorzugtesten besser als 500 nm, am allerbevorzugtesten besser als 50 nm.

Die Kammer kann vollständig evakuiert und mit einer beliebigen Gasmischung bzw. einem einzelnen Gas geflutet werden. Die Kammer und/oder die erfindungsgemäßen Substrathalter sind temperierbar, d.h. heiz- und/oder kühlbar. Die Kammer und/oder die Substrathalter können insbesondere auf eine Temperatur zwischen -75°C und 300°C, vorzugsweise zwischen -50°C und 250°C, noch bevorzugter zwischen -25°C und 200°C, am bevorzugtesten zwischen 0°C und 150°C, am allerbevorzugtesten zwischen 25°C und 100°C temperiert werden.

### Verfahren

In einem ersten erfindungsgemäßen Prozessschritt eines erfindungsgemäß ersten Prozesses wird ein erstes Substrat auf den erfindungsgemäßen ersten Substrathalter geladen. Die Aufnahmefläche des ersten Substrathalters ist insbesondere konkav gekrümmt, sodass das an der Aufnahmefläche aufzunehmende erste Substrat durch die Aufnahme an der Aufnahmefläche ebenfalls konkav gekrümmt wird. Insbesondere gleichzeitig wird ein zweites Substrat auf eine zweite Aufnahmefläche eines zweiten Substrathalters geladen und fixiert. Insbesondere kann der zweite Substrathalter gleich gestaltet sein, wie der erste Substrathalter. Vorzugsweise handelt es sich beim zweiten Substrathalter aber um einen Substrathalter mit ebener Aufnahmefläche. Die Aufnahme des zweiten Substrats kann vor, während oder nach der Aufnahme des ersten Substrats stattfinden.

In einem zweiten Prozessschritt erfolgt eine Ausrichtung des ersten Substrats relativ zum zweiten Substrat. Die Ausrichtung kann dabei insbesondere mechanisch und/oder optisch erfolgen. Handelt es sich bei der Ausrichtung nur um einen groben Ausrichtungsprozess, der insbesondere bei einem temporären Bondprozess verwendet wird, erfolgt die Ausrichtung vorzugsweise rein mechanisch. Bevorzugt werden die beiden Substrate allerdings über Ausrichtungsmarkierungen, insbesondere mit Hilfe optischer Mittel, zueinander ausgerichtet.

Spätestens in einem dritten erfindungsgemäßen Prozessschritt eines erfindungsgemäß ersten Prozesses erfolgt eine, zumindest teilweise, Evakuierung der Kammer, in der sich die beiden Substrathalter und Substrate befinden. Dieser Prozessschritt kann bereits vor und/oder während der Aufnahme und/oder Ausrichtung der Substrate stattfinden. Durch die Evakuierung der Kammer wird sichergestellt, dass sich keine Moleküle und/oder Atome zwischen den beiden Substraten befinden oder auf diesen ablagern. Insbesondere bei einer nicht umfangsgeschlossenen ringförmigen Kontaktierung (Verbindungsinitiierungfläche) könnte die Evakuierung auch noch nach der Kontaktierung, insbesondere kontinuierlich fortgesetzt, erfolgen. Bevorzugt erfolgt die ringförmige Kontaktierung beider Substrate vollumfänglich, insbesondere am Rand der Substrate. Die Evakuierung wird demnach bevorzugt vor diesem Prozessschritt der Kontaktierung durchgeführt.

Der Druck in der Kammer wird insbesondere auf weniger als 1 bar, vorzugsweise weniger als 10⁻² mbar, noch bevorzugter weniger als 10⁻⁴ mbar, am bevorzugtesten weniger als 10⁻⁶ mbar, am allerbevorzugtesten weniger als 10⁻⁸ mbar reduziert (Evakuierung). Dies dient insbesondere dazu, dass sich keine Atome oder Moleküle zwischen den Substraten befinden, wenn durch weitere erfindungsgemäße Prozessschritte eine vollflächige Kontaktierung der beiden Substrate erfolgt, da die Atome und Moleküle zwischen den Substraten keine Möglichkeit mehr haben, den Zwischenraum nach einer ringförmigen, umfangsgeschlossenen Kontaktierung zu verlassen. Der Zwischenraum wäre dann mit der Kontaktierung entlang der Verbindungsinitiierungsfläche nämlich hermetisch abgeschlossen.

Wird der erfindungsgemäße Prozess zum Fusionsbonden zweier Substrate verwendet, könnten die eingeschlossenen Atome und Moleküle Gasblasen zwischen den Substraten erzeugen, die den Substratstapel nahezu unbrauchbar machen würden. Bei der Verwendung der erfindungsgemäßen Methode zum Temporärbonden mit Klebern hingegen, kann eine geringe Menge an Gasen zwischen den Substraten toleriert werden, da der verwendete Kleber eine gewisse Menge an Gasen aufnehmen kann.

In einer anderen erfindungsgemäßen Ausführungsform wird der erfindungsgemäße Prozess für das Hybridbonden verwendet. Beim Hybridbonden handelt es sich um einen Fusionsbond zwischen zwei Hybridoberflächen. Eine Hybridoberfläche ist eine Oberfläche, die aus elektrischen und dielektrischen Bereichen besteht. Bei den elektrischen Bereichen handelt es sich vorzugsweise um Kontakte von, unter der dielektrischen Schicht hergestellten, funktionalen Bauteilen. Die elektrischen Bereiche werden dann auch als Durchkontaktierungen (engl.: through-siliconvias, TSVs) bezeichnet. Die Oberflächen der elektrischen Bereiche sind in Bezug zu den Oberflächen der dielektrischen Bereiche vorzugsweise ein wenig zurückgesetzt.

Die Höhendifferenz zwischen den Oberflächen der elektrischen und dielektrischen Bereiche ist dabei geringer als 1µm, vorzugsweise geringer als 500nm, noch bevorzugter geringer als 50nm, am bevorzugtesten kleiner als 5nm, am allerbevorzugtesten kleiner als 1nm. Durch die vorzugsweise zurückgesetzten elektrischen Bereiche kann sich die Bondwelle eines Fusionsbonds problemlos über die dielektrischen Bereiche bewegen, ohne von den elektrischen Bereichen in ihrem Fortschreiten gehindert zu werden.

Nach dem Fusionsbond über die dielektrischen Bereiche wird der Substratstapel wärmebehandelt. Die Wärmebehandlung führt vorzugsweise dazu, dass sich gegenüberliegende elektrische Bereiche beider Substrate, aufgrund der thermischen Belastung soweit ausdehnen, dass sie miteinander kontaktieren und über einen Metallbond, insbesondere einen Metalldiffusionsbond, miteinander permanent verbunden werden. Hybridbonds haben daher den Vorteil, dass durch sie die Verbindung zweier Substrate durch einen Fusionsprozess sehr einfach und kostengünstig hergestellt werden kann.

Das erfindungsgemäße Verfahren zeigt insbesondere vorteilhaft eine Möglichkeit zur Ausbildung eines solchen Hybridbonds auf. Vorteilhaft wird im erfindungsgemäßen Prozess eine Verbindung der beiden Substrate, vorzugsweise unter Vakuum, an der Peripherie durchgeführt. Vorteilhaft befindet sich nach der, insbesondere vollumfänglichen, peripheren, Kontaktierung beider Substrate, kein Gas mehr zwischen den Substraten. Durch die Entfernung des Gases zwischen den Substraten fällt ein möglicher Einflussfaktor weg, der eine fortschreitende Bondwelle beeinflussen könnte. Das, insbesondere obere, von außerhalb betrachtet konvex gekrümmte, Substrat wird ausschließlich durch seine elastische Eigenschaft und seiner peripheren Fixierung zum zweiten Substrat in seiner Kuppelform stabilisiert.

Durch die Druckerhöhung ist nun ein gezieltes und vor allem steuerbares Flachdrücken des gekrümmten Substrats, möglich, ohne einen Widerstand eines Gases zwischen den Substraten berücksichtigen zu müssen. Die Bondwelle läuft nun vorteilhaft von der Peripherie zum Zentrum.

In einem vierten Prozessschritt erfolgt eine relative Annäherung der beiden Substrate zueinander, die vorzugsweise nach dem Kontakt des ersten, konkav gekrümmten Substrats mit dem zweiten Substrat entlang der Verbindungsinitiierungsfläche beendet wird. Denkbar, wenn auch weniger bevorzugt, ist auch, dass die Relativbewegung zwischen beiden Substraten noch vor deren Kontaktierung beendet wird. In diesem Fall wird die Fixierung des oberen Substrathalters gelöst und das obere Substrat fällt über eine, insbesondere relativ kurze Strecke von einigen Millimetern, vorzugsweise wenigen Mikrometern, noch bevorzugter wenigen Nanometern, auf das untere Substrat. Nachdem das obere, erfindungsgemäß konkav gekrümmte Substrat das untere Substrat entlang seiner Peripherie berührt, werden beide Substrate entlang der Peripherie durch Oberflächenmechanismen vorfixiert.

In einem fünften Prozessschritt erfolgt die Erhöhung des Drucks in der Kammer. Insbesondere wird ein Ventil zur Atmosphäre geöffnet, sodass sich im inneren der Kammer wieder der Atmosphärendruck einstellt. Denkbar ist aber auch, dass ein Gas bzw. eine Gasmischung, in die Kammer eingebracht wird, die bevorzugt aus Inertgasatomen bzw. Inertgasmolekülen besteht. Durch die Erzeugung eines erhöhten Drucks, insbesondere durch einen Kompressor, wird das konkav gekrümmte Substrat kontinuierlich, insbesondere schlagartig, eben gedrückt, da zwischen dem Kammerraum und dem vom Kammerraum durch den Kontakt zwischen den Substraten getrennten Hohlraum eine Druckdifferenz aufgebaut wird.

Durch ein gesteuertes, langsames Einlassen eines Gases bzw. einer Gasmischung kann das gekrümmte Substrat insbesondere auch gesteuert und sehr langsam flachgedrückt werden.

In einer besonderen erfindungsgemäßen Erweiterung wird während des gesteuerten und langsamen Flachdrückens des gekrümmten Substrats eine kontinuierliche Überwachung des gekrümmten Substrats und/oder des gesamten Substratstapels und/oder des Zwischenraums der beiden Substrate durchgeführt. Vorzugsweise wird insbesondere eine Überprüfung der Ausrichtungsgenauigkeit zwischen einzelnen Merkmalen beider Substrate durchgeführt. Erfindungsgemäß ist insbesondere denkbar, dass noch während des Flachdrückens des gekrümmten Substrats eine fehlerhafte Ausrichtung festgestellt und der Prozess darauf hin unterbrochen wird. Das obere, noch gekrümmte Substrat wird in diesem Fall vorzugsweise wieder vom erfindungsgemäßen Substrathalter fixiert und vom unteren Substrat entfernt. Daraufhin kann in der erfindungsgemäßen Vorrichtung eine erneute, verbesserte Ausrichtung zwischen den beiden Substraten erfolgen.

Bei diesem erfindungsgemäßen Prozessschritt wandert der Rand des konkav gekrümmten Substrats kontinuierlich radial nach außen, während das Zentrum des ersten Substrats sich dem zweiten Substrat annähert. Insbesondere bleibt der Kontakt zwischen den beiden Substraten während des erfindungsgemäßen Prozessschrittes stets erhalten, so dass keine Verunreinigungen zwischen die Substrate gelangen.

Dieser Prozess findet auch dann statt, wenn die Kontaktierung des ersten Substrats mit dem zweiten Substrat nicht vollumfänglich erfolgt ist.

Der vorbeschriebene Prozess kann abgewandelt werden und unterscheidet sich nur in einigen nachfolgend beschriebenen Punkten.

Im dritten Prozessschritt wird im Gegensatz zum vorbeschriebenen Prozess keine Evakuierung der Kammer durchgeführt. Insbesondere bleibt die Kammer zur Atmosphäre hin offen.

Dafür wird im fünften Prozessschritt in der Kammer ein Überdruck in Bezug zur äußeren Atmosphäre angelegt. Insbesondere wird die Kammer hierzu hermetisch (druckdicht) verriegelt. Denkbar ist allerdings auch, dass die Kammer zur Atmosphäre hin über Ventile geöffnet ist, wobei durch einen hohen Volumenstrom ein Überdruck in der Kammer erzeugt wird.

Vorrichtungsgemäß offenbarte Merkmale sollen auch als verfahrensgemäß offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: einen ersten Prozessschritt einer Ausführungsform des erfindungsgemäßen Verfahrens,
- Figur 1b: einen zweiten Prozessschritt der Ausführungsform gemäß Figur 1a,
- Figur 1c: einen dritten Prozessschritt der Ausführungsform gemäß Figur 1a,
- Figur 1d: einen vierten Prozessschritt der Ausführungsform gemäß Figur 1a,
- Figur 1e: einen fünften Prozessschritt der Ausführungsform gemäß Figur 1a,
- Figur 1f: einen sechsten Prozessschritt der Ausführungsform gemäß Figur 1a,
- Figur 2: eine erste Ausführungsform eines erfindungsgemäßen Substrathalters,
- Figur 3: eine zweite Ausführungsform eines erfindungsgemäßen Substrathalters,
- Figur 4: eine dritte Ausführungsform eines erfindungsgemäßen Substrathalters,
- Figur 5: eine vierte Ausführungsform eines erfindungsgemäßen Substrathalters,
- Figur 6: eine fünfte Ausführungsform eines erfindungsgemäßen Substrathalters,
- Figur 7: eine erste Ausführungsform eines Substrats,
- Figur 8: eine zweite Ausführungsform des Substrats und
- Figur 9: eine dritte Ausführungsform des Substrats.

In den Figuren sind gleiche Bauteile oder Bauteile mit der gleichen Funktion mit den gleichen Bezugszeichen gekennzeichnet.

Alle Figuren sind nicht maßstabsgetreu gezeichnet, um die Darstellung zu vereinfachen und das Verständnis zu erleichtern. Insbesondere sind die Krümmungen der Substrate zu groß dargestellt.

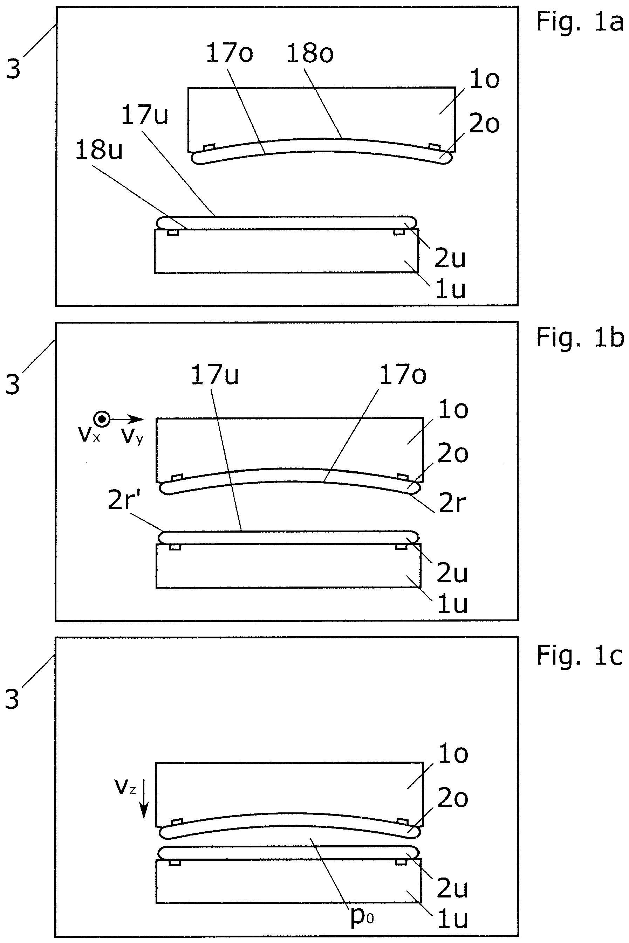

Die Figur 1a zeigt einen ersten Prozessschritt, bei dem ein erstes Substrat 2o auf eine erste Aufnahmefläche 18o eines ersten Substrathalters lo geladen und fixiert worden ist. Insbesondere gleichzeitig ist die Fixierung eines zweiten Substrats 2u auf eine zweite Aufnahmefläche 18u eines zweiten Substrathalters 1u erfolgt. Die Fixierung beider Substrate 2u, 2o findet vorzugsweise innerhalb einer Kammer 3 statt. Denkbar wäre aber auch, dass das Substrat 2u und/oder das Substrat 2o außerhalb der Kammer 3 auf einem Substrathalter fixiert und dann mit dem Substrathalter in die Kammer 3 transportiert werden.

Die Figur 1b zeigt einen zweiten Prozessschritt, bei dem eine Ausrichtung der beiden Substrate 2u, 2o zueinander, insbesondere eine Ausrichtung von deren Kontaktflächen 17u, 17o erfolgt. Bei der Ausrichtung kann es sich um eine Grob- und/oder eine Feinausrichtung handeln. Eine Feinausrichtung erfolgt vorzugsweise über Ausrichtungsmarken (nicht dargestellt, da an sich bekannt) und Optiken 9. Die Ausrichtung erfolgt vorzugsweise in x- und/oder y-Richtung (Geschwindigkeiten vₓ, v_{y}) und/oder in Rotationsrichtung der Substrate 2u, 2o. Die Krümmung des oberen Substrats 2o ist in der Figur stark übertrieben dargestellt. Für eine optische Ausrichtung der beiden Substrate 2u, 2o zueinander können die Kontaktflächen 17u, 17o als mehr oder weniger parallel zueinander angesehen werden.

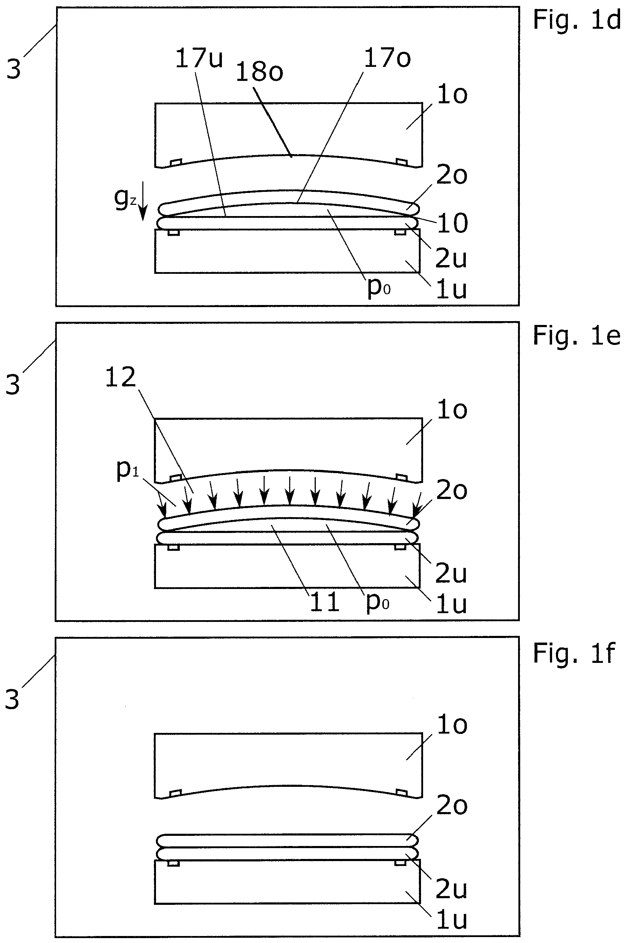

Die Figur 1c zeigt einen dritten Prozessschritt, bei dem eine relative Annäherung der beiden Substrate 2u, 2o, insbesondere durch die relative Bewegung der beiden Substrathalter 1u, 1o zueinander erfolgt (Geschwindigkeit v_{z}). Spätestens in diesem Prozessschritt beginnt eine Evakuierung der Kammer 3, welche einen möglichst geringen Kammerdruck p innerhalb der Kammer 3erzeugt. Die Erzeugung des Vakuums kann aber schon vor dem dritten Prozessschritt beginnen und wird abgeschlossen, bevor die Substrate 2u, 2o kontaktieren (Fig. 1d).

Die Figur 1d zeigt einen vierten Prozessschritt, bei dem das konkav gekrümmte erste Substrat 2o auf dem zweiten Substrat 2u fixiert wird. Befindet sich das erste, konkav gekrümmte Substrat 2o an einem oberen Substrathalter 1o, kann das erste Substrat 2o entweder durch Annäherung bis Kontaktierung oder durch Fallenlassen das zweite Substrat 2u kontaktieren. Vorzugsweise erfolgt die Kontaktierung zunächst ausschließlich an einer Verbindungsinitiierungsfläche 10. Die Verbindungsinitiierungsfläche 10 wird von den Kontaktflächen zwischen 17u und 17o der Substrate 2u, 2o zum Beginn der Kontaktierung der Substrate 2u, 2o gebildet. Die Kontaktierung erfolgt zunächst entlang der Seitenränder 2r, 2r` der Kontaktflächen 17u, 17o, insbesondere vollumfänglich.

Die Figur 1e zeigt einen fünften Prozessschritt, bei dem der Kammerdruck p1 in der Kammer 3 größer als der unmittelbar vor Kontaktierung vorliegende Kammerdruck p0 eingestellt wird. Durch die so entstehende Druckdifferenz zwischen einem durch die konkave Verformung des ersten Substrats 2o gebildeten Hohlraum 11 und dem außerhalb der Substrate 2u, 2o liegenden Kammerraum 12, wirkt ein, insbesondere isotroper, Druck auf das freiliegende erste Substrat 2o und drückt es auf das von dem zweiten Substrathalter unterstützte zweite Substrat 2u.

Die Figur 1f zeigt einen sechsten Prozessschritt, bei dem die Verbindung, insbesondere der Bond, zwischen dem ersten Substrat 2o und dem zweiten Substrat 2u hergestellt ist.

Im weiteren Verlauf des Textes werden einzelne Ausführungsformen von ersten Substrathaltern 1o , 1o', 1o", 1o‴, 1oʺʺ beschrieben. Bevorzugt bestehen die erfindungsgemäßen ersten Substrathalter 1o , 1o', 1o", 1o‴, 1oʺʺ aus mehreren Bauteilen. Die gezeigten Substrathalter 1o , 1o', 1o", 1o‴, 1oʺʺ werden schematisch mit der minimal nötigen Anzahl an Bauteilen dargestellt, die für die Darstellung der erfindungsgemäßen Funktionen wichtig sind. Ansonsten können die Substrathalter 1o , 1o', 1o", 1o‴, 1oʺʺ übliche Merkmale aufweisen, die hier nicht dargestellt sind.

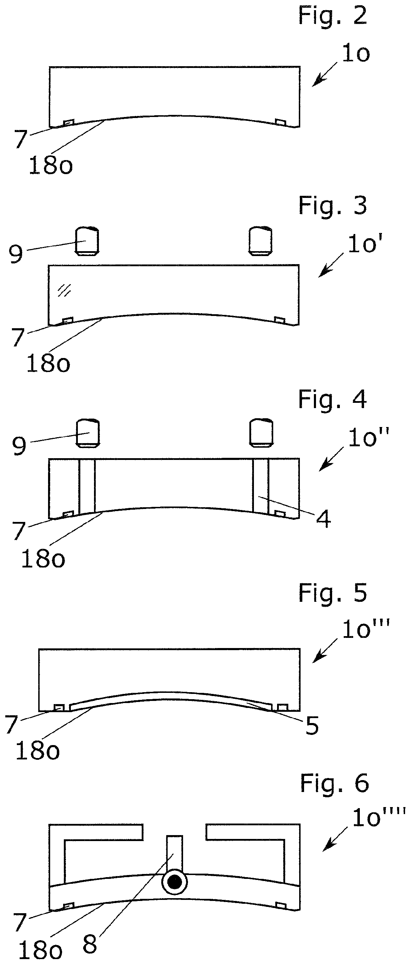

Die Figur 2 zeigt eine erste Ausführungsform des ersten Substrathalters 1o, der massiv ist. Der Substrathalter 1o ist insbesondere impermeabel für elektromagnetische Strahlung aus dem UV-, dem sichtbaren und dem Infrarotbereich. Der Substrathalter 1o verfügt über Fixierungen 7 zur Fixierung des ersten Substrats 2o an der statischen, konkaven Aufnahmefläche 18o.

Die Figur 3 zeigt eine zweite Ausführungsform eines Substrathalters 1o', der transparent ist. Durch die Transparenz können Merkmale, insbesondere Ausrichtungsmarken, auf dem Substrat durch den Substrathalter 1o' mittels der Optiken 9 erkannt und/oder vermessen werden.

Die Figur 4 zeigt eine dritte Ausführungsform eines Substrathalters 1o", der über Bohrungen 4 verfügt, durch welche Merkmale des am Substrathalter 1o" fixierten Substrats 2o mittels der Optiken 9 erkannt und/oder vermessen werden können.

Die Figur 5 zeigt eine vierte Ausführungsform eines Substrathalters 1o‴, der über eine Materialschicht 5 verfügt, welche, insbesondere elektrisch und/oder magnetisch und/oder thermisch so geschalten werden kann, dass es zu einer Volumenkontraktion oder Volumenexpansion kommt. Diese Volumenänderung findet vorwiegend im Kubikmikrometer- bis Kubikmillimeterbereich statt. Trotz der geringen Volumenänderung kann dadurch die konkave Aufnahmefläche verändert werden.

Bei der Materialschicht 5 kann es sich beispielsweise um eine magnetrheologische, eine elektrorheologische oder eine Formgedächtnislegierung handeln. Insbesondere Formgedächtnislegierungen sind in der Lage, durch eine thermische induzierte Phasenumwandlung das Volumen und damit die Form der konkaven Aufnahmefläche 18o zu ändern. Handelt es sich bei der Materialschicht 5 um eine magnetrheologische oder elektrorheologische Materialschicht 5, müssen entsprechende elektronische und/oder elektrotechnische Bauelemente im Substrathalter 1o‴ vorgesehen werden, um magnetische bzw. elektrische Felder erzeugen zu können, die zu einer Änderung des Volumens der konkaven Aufnahmefläche 18o durch eine physikalische Beeinflussung der Materialschicht 5 führen. Diese Bauelemente sind der Übersichtlichkeit halber nicht eingezeichnet. Insbesondere handelt es sich dabei um Spulen oder Elektroden.

Die Figur 6 zeigt eine fünfte Ausführungsform eines Substrathalters 1oʺʺ, welcher durch Stellmittel 8 zu einer Änderung der konkaven Aufnahmefläche 18o verwendet werden kann. Bei dem Stellmittel 8 kann es sich insbesondere um ein
- Mechanisches Stellmittel
- Pneumatisches Stellmittel
- Hydraulisches Stellmittel
- Elektrisches Stellmittel, insbesondere ein Piezoelement handeln. Insbesondere können mehrere Stellmittel 8 im Substrathalter 1oʺʺ verteilt sein um die Krümmung der konkaven Aufnahmefläche 18o örtlich zu variieren.

Merkmale der beschriebenen unterschiedlichen Substrathalter 1o, 1o', 1o", 1o‴, 1oʺʺ können miteinander kombiniert werden, um neue erfindungsgemäße Substrathalter zu erzeugen. So ist es denkbar, dass ein Substrathalter erzeugt wird, der die Bohrungen aus dem Substrathalter 1o" der Figur 4 mit der Materialschicht 5 des Substrathalters 1o‴ der Figur 5 kombiniert. Diese Kombinationen werden hiermit ebenfalls explizit offenbart.

In den weiteren Figuren werden die unterschiedlichen Substrate, die für die erfindungsgemäßen Prozesse und Ausführungsformen Verwendung finden, dargestellt. Sie können sich insbesondere am oberen Substrathalter 1o oder unteren Substrathalter 1u befinden. Insbesondere werden aber die Substrate 2` und 2" als Träger bezeichnet und befinden sich bevorzugt am unteren Substrathalter 1u. Im Falle eines Fusionsbonds würde sich auch am unteren Substrathalter ein Substrat 2 vorfinden.

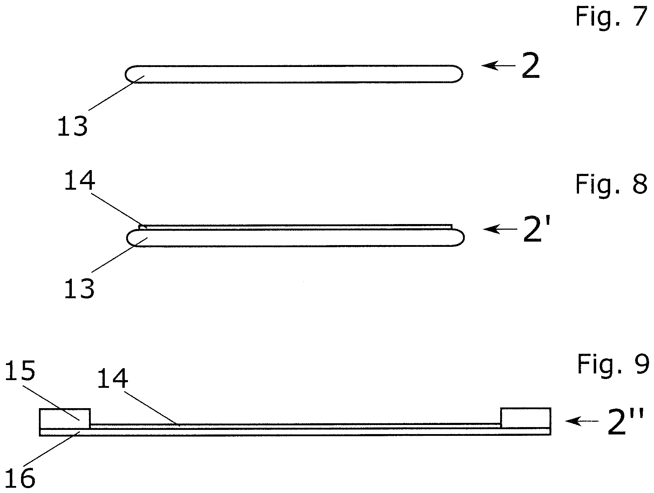

Die Figur 7 zeigt die einfachste Ausführungsform eines Substrats 2. Bei dem Substrat 2 handelt es sich vorzugsweise um einen unstrukturierten oder strukturierten Wafer 13.

Die Figur 8 zeigt ein Substrat 2', bestehend aus einem Wafer 13 und eine Klebeschicht 14. Die Klebeschicht 14 ist vorzugsweise ein Bondingadhäsiv und wird beispielsweise durch einen Schleuderbelackungsprozess auf den Wafer 13 aufgebracht.

Die Figur 9 zeigt ein Substrat 2", bestehend aus einer Folie 16, die auf einen Rahmen 15 aufgespannt wurde. Die Folie 16 besitzt an ihrer Oberfläche vorzugsweise eine Klebeschicht 14.Vorrichtung und Verfahren zum Verbinden von Substraten

### Bezugszeichenliste

- 1u, 1o: Substrathalter
- 2, 2u, 2o: Substrate
- 2r, 2r': Seitenränder
- 3: Kammer
- 4: Bohrungen
- 5: Materialschicht
- 7: Fixierungen
- 8: Stellmittel
- 9: Optiken
- 10: Verbindungsinitiierungsfläche
- 11: Hohlraum
- 12: Kammerraum
- 13: Wafer
- 14: Klebeschicht
- 15: Folie
- 16: Rahmen
- 17u, 17o: Kontaktflächen
- 18u, 18o: Aufnahmeflächen
- vₓ, v_{y}, v_{z}: Geschwindigkeiten

## Patentansprüche

1. Verfahren zum Verbinden eines ersten Substrats (2o) mit einem zweiten Substrat (2u) an Kontaktflächen (17u, 17o) der Substrate (2o, 2u) mit folgenden Schritten, insbesondere folgendem Ablauf:
- Aufnahme des ersten Substrats (2o) an einer ersten Aufnahmefläche (18o) eines ersten Substrathalters (1o) und Aufnahme des zweiten Substrats (2u) an einer zweiten Aufnahmefläche (18u) eines zweiten Substrathalters (1u), wobei die Substrathalter (1o, 1u) in einer Kammer (3) angeordnet sind,
- Kontaktierung der Kontaktflächen (17u, 17o) an einer Verbindungsinitiierungsfläche (10), wobei eine ringförmige Kontaktierung erfolgt,
- Verbinden des ersten Substrats (2o) mit dem zweiten Substrat (2u) von der Verbindungsinitiierungsfläche (10) zum Zentrum der Substrate (2o, 2u).

2. Verfahren gemäß Anspruch 1, bei dem nach der Kontaktierung und/oder während des Verbindens ein Kammerdruck in der Kammer (3) erhöht wird.

3. Verfahren nach einem der vorhergehenden Ansprüche, bei dem die Verbindungsinitiierungsfläche (10) am Umfangsrand mindestens einer der Kontaktflächen (17u, 17o) angeordnet ist.

4. Verfahren nach einem der vorhergehenden Ansprüche, bei dem vor der Kontaktierung eine konkave Verformung des ersten Substrats (2o) gegenüber dem zweiten Substrat (2u), insbesondere durch Aufnahme des ersten Substrats (2o) an der entsprechend konkav gekrümmten ersten Aufnahmefläche (18o) erfolgt.

5. Verfahren nach einem der vorhergehenden Ansprüche, bei dem die, insbesondere umfangsgeschlossene, Verbindungsinitiierungsfläche (10) ringförmig, insbesondere kreisringförmig, vorzugsweise konzentrisch zum Zentrum der Substrate (2u, 2o) verlaufend ausgebildet ist.

6. Verfahren nach einem der vorhergehenden Ansprüche, bei dem das erste Substrat (2o) und/oder das zweite Substrat (2u) ausschließlich im Bereich von Seitenrändern (2r, 2r') der Kontaktflächen (17o, 17u) rückwärtig an den ersten und/oder zweiten Aufnahmeflächen (18o, 18u) fixiert werden.

7. Vorrichtung zum Verbinden eines ersten Substrats (2o) mit einem zweiten Substrat (2u) an Kontaktflächen (17u, 17o) der Substrate (2u, 2o) mit:
- einer ersten Aufnahmefläche (18o) eines ersten Substrathalters (1o) zur Aufnahme des ersten Substrats (2o),
- einer zweiten Aufnahmefläche (18u) eines zweiten Substrathalters (1u) zur Aufnahme des zweiten Substrats (2u),
- einer Kammer (3), in der die Substrathalter (1u, 1o) angeordnet sind,
- Mitteln zur Kontaktierung der Kontaktflächen (17u, 17o) an einer Verbindungsinitiierungsfläche (10), wobei eine ringförmige Kontaktierung erfolgt,
- Mitteln zum Verbinden des ersten Substrats (2o) mit dem zweiten Substrat (2u) von der Verbindungsinitiierungsfläche (10) zum Zentrum der Substrate (2u, 2o).

## Claims

1. A method for bonding a first substrate (2o) with a second substrate (2u) at contact surfaces (17u, 17o) of the substrates (2o, 2u) with the following steps, in particular in the following sequence:
- mounting of the first substrate (2o) on a first mounting surface (18o) of a first substrate holder (1o) and mounting of the second substrate (2u) on a second mounting surface (18u) of a second substrate holder (1u), wherein the substrate holders (1o, 1u) are arranged in a chamber (3),
- contacting of the contact surfaces (17u, 17o) at a bond initiation surface (10), wherein a ring-shaped contacting takes place,
- bonding of the first substrate (2o) with the second substrate (2u) from the bond initiation surface (10) to the centre of the substrates (2o, 2u).

2. The method according to claim 1, wherein a chamber pressure is raised in the pressure chamber (3) after the contacting and/or during the bonding.

3. The method according to any one of the preceding claims, wherein the bond initiation surface (10) is arranged at the peripheral edge of at least one of the contact surfaces (17u, 17o).

4. The method according to any one of the preceding claims, wherein a concave deformation of the first substrate (2o) with respect to the second substrate (2u), in particular by mounting of the first substrate (2o) on the first mounting surface (18o) correspondingly curved in a concave manner, takes place before the contacting.

5. The method according to any one of the preceding claims, wherein the in particular circumferentially closed bond initiation surface (10) is constituted in ring-shaped, in particular circular ring-shaped, preferably running concentrically to the centre of the substrates (2u, 2o).

6. The method according to any one of the preceding claims, wherein the first substrate (2o) and/or the second substrate (2u) are fixed set back on the first and/or second mounting surfaces (18o, 18u) exclusively in the region of side edges (2r, 2r') of the contact surfaces (17o, 17u).

7. A device for bonding a first substrate (2o) with a second substrate (2u) at contact surfaces (17u, 17o) of the substrates (2u, 2o) with:
- a first mounting surface (18o) of a first substrate holder (1o) for mounting the first substrate (2o),
- a second mounting surface (18u) of a second substrate holder (1u) for mounting a second substrate (2u),
- a chamber (3), in which the substrate holders (1u, 1o) are arranged,
- means for contacting the contact surfaces (17u, 17o) at a bond initiation surface (10), wherein a ring-shaped contacting takes place,
- means for the bonding of the first substrate (2o) and the second substrate (2u) from the bond initiation surface (10) to the centre of the substrates (2u, 2o).

## Revendications

1. Procédé de liaison d'un premier substrat (2o) avec un deuxième substrat (2u) sur des surfaces de contact (17u, 17o) des substrats (2o, 2u), présentant les étapes suivantes, notamment le déroulement suivant, consistant à :
- réceptionner le premier substrat (2o) sur une première surface de réception (18o) d'un premier support de substrat (1o) et réceptionner le deuxième substrat (2u) sur une deuxième surface de réception (18u) d'un deuxième support de substrat (1u), les supports de substrat (1o, 1u) étant placés dans un compartiment (3),
- mettre en contact les surfaces de contact (17u, 17o) sur une surface (10) initiatrice de liaison, une mise en contact de forme annulaire étant effectuée,
- relier le premier substrat (2o) avec le deuxième substrat (2u), de la surface (1o) initiatrice de liaison vers le centre des substrats (2o, 2u).

2. Procédé selon la revendication 1, lors duquel après la mise en contact et / ou pendant la liaison, l'on augmente une pression de compartiment dans le compartiment (3).

3. Procédé selon l'une quelconque des revendications précédentes, lors duquel la surface (10) initiatrice de liaison est placée sur le bord périphérique d'au moins l'une des surfaces de contact (17u, 17o).

4. Procédé selon l'une quelconque des revendications précédentes, lors duquel, avant la mise en contact a lieu une déformation concave du premier substrat (2o) par rapport au deuxième substrat (2u), notamment par réception du premier substrat (2o) sur la première surface de réception (18o) recourbée en conséquence de forme concave.

5. Procédé selon l'une quelconque des revendications précédentes, lors duquel la surface (10) initiatrice de liaison, notamment fermée sur sa périphérie est conçue de forme annulaire, notamment en forme d'anneau circulaire, de préférence en s'écoulant de manière concentrique par rapport au centre des substrats (2u, 2o).

6. Procédé selon l'une quelconque des revendications précédentes, lors duquel, exclusivement dans la zone de bords latéraux (2r, 2r') des surfaces de contact (170, 17u), l'on fixe le premier substrat (2o) et / ou le deuxième substrat (2u) sur la face arrière sur les premières et / ou les deuxièmes surfaces de réception (18o 18u).

7. Dispositif de liaison d'un premier substrat (2o) avec un deuxième substrat (2u) sur des surfaces de contact (17u, 17o) des substrats (2u, 2o), comprenant :
- une première surface de réception (18o) d'un premier support de substrat (1o), destinée à réceptionner le premier substrat (2o),
- une deuxième surface de réception (18u) d'un deuxième support de substrat (1u), destinée à réceptionner le deuxième substrat (2u),
- un compartiment (3), dans lequel est placé le support de substrat (1u, 1o),
- des moyens de mise en contact des surfaces de contact (17u, 17o) sur une surface (10) initiatrice de liaison, une mise en contact de forme annulaire étant effectuée,
- des moyens de liaison du premier substrat (2o) avec le deuxième substrat (2u), de la surface (10) initiatrice de liaison vers le centre des substrats (2u, 2o).
